Europäisches Patentamt

European Patent Office

Office européen des brevets

(11) Veröffentlichungsnummer: **0 297 272**
**A2**

## (12) EUROPÄISCHE PATENTANMELDUNG

(21) Anmeldenummer: **88108119.4**

(22) Anmeldetag: **20.05.88**

(51) Int. Cl.⁴: **H03L 7/18**

(30) Priorität: **26.06.87 DE 3721154**

(43) Veröffentlichungstag der Anmeldung:
**04.01.89 Patentblatt 89/01**

(84) Benannte Vertragsstaaten:
**AT BE CH DE FR GB IT LI NL SE**

(71) Anmelder: **Wegmann & Co. GmbH**
**August-Bode-Strasse 1**
**D-3500 Kassel(DE)**

(72) Erfinder: **Der Erfinder hat auf seine Nennung**
**verzichtet**

(74) Vertreter: **Feder, Wolf-Dietrich et al**
**Dr. Wolf-D. Feder, Dr. Heinz Feder Dipl.-Ing.**
**P.-C. Sroka Dominikanerstrasse 37**
**D-4000 Düsseldorf 11(DE)**

(54) **Frequenzsynthesizer.**

(57) Ein Frequenzsynthesizer mit einem spannungsgeregelten Oszillator (1), der über seinen ganzen Frequenzbereich mittels eines Drehkondensators (2) abstimmbar ist und mit einem Referenzoszillator (6), der ein Referenzsignal mit fest vorgegebener Frequenz abgibt, das als erstes Eingangssignal (ES1) einem Komparator (5) zugeführt wird, dem gleichzeitig ein zweites Eingangssignal (ES2) zugeführt wird, das mittels eines einstellbaren Frequenzteilers (4) aus dem Ausgangssignal des Oszillators (1) erzeugt wird. Der Komparator (5) erzeugt in Abhängigkeit von der Frequenzdifferenz seiner beiden Eingangssignale ein Nachstimmsignal (UAFC), welches dem Oszillator (1) zur Nachstimmung der Frequenz seines Ausgangssignals auf den durch das Referenzsignal definierten Wert zugeführt wird. Die Einstellung des Teilungsfaktors am Frequenzteiler (4) erfolgt durch einen von einem Taktgeber (9) angesteuerten Zähler (10), der den Teilungsfaktor solange verändert, bis die Spannung des Nachstimmsignals innerhalb eines vorgegebenen Spannungsbereiches (Umax- Umin) liegt, in dem das System auf eine Frequenz einrastet, die dem Produkt aus der Frequenz des Referenzsignals und dem Teilungsfaktor entspricht.

FIG.1

Gegenstand der Erfindung ist ein Frequenzsynthesizer mit den Merkmalen aus dem Oberbegriff des Patentanspruchs 1.

Derartige Frequenzsynthesizer sind in verschiedenen Ausführungsformen bekannt. Der Referenzoszillator ist im allgemeinen ein Quarzoszillator, der ein in der Frequenz hochstabilisiertes Referenzsignal liefert.

Das zweite, dem Komparator zugeführte Eingangssignal, dessen Frequenz eine Funktion der Frequenz des Ausgangssignals sein soll, wird im allgemeinen erzeugt, indem mindestens ein zweiter Referenzoszillator vorhanden ist, der beispielsweise als Spektrumgenerator ausgebildet sein kann, so daß sein Ausgangssignal diskrete Werte eines vorgegebenen Frequenzspektrums enthält. Das Ausgangssignal des zweiten Referenzoszillators wird mit dem Ausgangssignal des spannungsgeregelten Oszillators gemischt und das Ausgangssignal des Mischers wird über ein entsprechendes Bandpaßfilter dem Komparator zugeführt, in dem dann ein Signal, dessen Frequenz der Summe oder der Differenz aus der Frequenz des Ausgangssignals des spannungsgeregelten Oszillators und eines Signals mit einer der Frequenzen des zweiten Referenzoszillators entspricht, mit dem Ausgangssignal des ersten Referenzoszillators verglichen wird. Das erzeugte Kanalraster von Signalen entspricht dem Abstand der Spektrallinien des zweiten Referenzoszillators. Beträgt dieser Abstand beispielsweise 1 MHz, so kann das Ausgangssignal des spannungsgeregelten Oszillators auf Frequenzen im Abstand von 1 MHz stabilisiert werden. Die Nachstimmung des spannungsgeregelten Oszillators erfolgt dabei meist in der Weise, daß das vom Komparator abgegebene Nachstimmsignal über ein Regelschwingungen unterdrückendes Schleifenfilter einer, den spannungsgeregelten Oszillator steuernden Kapazitätsdiode zugeführt wird. Der Frequenzsynthesizer kann am Drehkondensator ungefähr auf die gewünschte Frequenz abgestimmt werden und rastet dann auf eine der festen Frequenzen ein, so daß er auf die Genauigkeit der Referenzfrequenz abgestimmt ist.

Wenn das auf diese Weise erzeugte Frequenzraster zu grob erscheint, kann noch ein dritter Oszillator Verwendung finden, der beispielsweise als Localoszillator mit umschaltbaren Quarzen benachbarter Frequenz ausgebildet sein kann und dessen Ausgangssignal über einen weiteren Mischer dem aus den Signalen des spannungsgeregelten Oszillators und des Spektrumgenerators erzeugten Signal zugemischt wird, wodurch ein Frequenzfeinraster erzeugt werden kann.

Auf diese Weise kann beispielsweise im Frequenzbereich zwischen 40 und 50 MHz für das Ausgangssignal des spannungsgeregelten Oszillators ein Frequenzraster mit Abständen von 25 kHz erzeugt werden, wobei die eingestellten Frequenzen eine Genauigkeit etwa in der Größenordnung von 2 bis 3 kHz besitzen.

Ein Nachteil dieser bekannten Frequenzsynthesizer ist ihr aufwendiger und komplizierter Aufbau mit mehreren Referenzoszillatoren und einer Reihe von schaltungstechnischen Maßnahmen zur Unterdrückung störender Nebenfrequenzen. Ein Vorteil dieser bekannten Ausführungsformen besteht darin, daß die Grobabstimmung durch einen verlustarmen Drehkondensator erfolgt und nur die Feinabstimmung mittels der verlustbehafteten und von Natur aus rauschenden Nachstimmdiode durchgeführt wird.

Es ist weiterhin ein Frequenzsynthesizer bekannt, bei dem der große Schaltungsaufwand der oben erwähnten Ausführungsform dadurch vermieden wird, daß das Ausgangssignal des spannungsgeregelten Oszillators einem einstellbaren Frequenzteiler zugeführt wird, dessen Teilungsfaktor so eingestellt wird, daß sein Ausgangssignal im Bereich der Frequenz des Referenzsignals liegt. Auch bei dieser Ausführungsform wird das vom Komparator gelieferte Nachstimmsignal einer Kapazitätsdiode zur Abstimmung des spannungsgeregelten Oszillators zugeführt. Ein Drehkondensator zur Grobabstimmung ist bei dieser Ausführungsform nicht vorgesehen, sondern die Ausgangsfrequenz wird allein durch die Einstellung des Teilungsfaktors am einstellbaren Frequenzteiler bestimmt.

Ein derartiger Frequenzsynthesizer läßt sich mit geringerem Aufwand aufbauen und seine Frequenzkonstanz hängt nur von einem einzigen Referenzoszillator ab. Sein wesentlicher Nachteil besteht darin, daß infolge der Verwendung einer Kapazitätsdiode für die Gesamtabstimmung ein erhebliches Rauschen in Kauf genommen werden muß.

Die der Erfindung zugrunde liegende Aufgabe bestand darin, einen Frequenzsynthesizer mit den eingangs und im Oberbegriff des Patentanspruchs 1 erwähnten Merkmalen zu schaffen, der einerseits mit geringem schaltungstechnischen Aufwand aufbaubar ist und insbesondere nur einen einzigen Referenzoszillator besitzt, der aber andererseits ein extrem rauscharmes Ausgangssignal liefert.

Die Lösung dieser Aufgabe erfolgt erfindungsgemäß mit den Merkmalen aus dem kennzeichnenden Teil des Patentanspruchs 1. Vorteilhafte Weiterbildungen des erfindungsgemäßen Frequenzsynthesizers sind in den Unteransprüchen beschrieben.

Die Erfindung geht von dem Grundgedanken aus, das Frequenzteilungsverhältnis nicht am Frequenzteiler fest vorzugeben, sondern lediglich eine Einstellung am frequenzbestimmenden Element vorzugeben, wonach durch die elektronische Einstellvorrichtung der Teilungsfaktor automatisch ausgewählt und eingestellt wird. Es handelt sich hier um einen Regelkreis, bei dem die zu regelnde Größe ein Frequenzteilungsfaktor ist. Als frequenzbestimmendes Element dient vorzugsweise ein Drehkondensator. Es kann aber auch z.B. ein Variometer verwendet werden.

Wie weiter unten anhand eines Ausführungsbeispiels gezeigt wird, läßt sich der erfindungsgemäße Frequenzsynthesizer mit geringem Schaltungsaufwand aufbauen und liefert ein extrem rauscharmes Ausgangssignal sehr hoher Frequenzgenauigkeit.

Darüber hinaus besitzt der erfindungsgemäße Frequenzsynthesizers den Vorteil, daß die Einstellmöglichkeiten für die Frequenzwahl gegenüber dem bekannten eingangs erwähnten Frequenzsynthesizer unverändert beigehalten sind, nämlich die Grobeinstellung durch Betätigung des Drehkondensators mit einer Möglichkeit zur Feineinstellung mittels eines einstellbaren Schalters. Auf diese Weise kann der äußere Aufbau bestimmter, bei den Benutzern eingeführter Geräte und die Art der Bedienung erhalten bleiben. Der erfindungsgemäße Frequenzsynthesizer ist daher vor allem in vorteilhafter Weise bei der Modernisierung von bekannten, bereits mit einem einstellbaren Drehkondensator ausgerüsteten Geräten verwendbar.

Weiterhin kann er zum Aufbau von besonders rauscharmen Meßsendern Verwendung finden.

Im folgenden werden anhand der beigefügten Zeichnungen zwei Ausführungsbeispiele für einen Frequenzsynthesizer nach der Erfindung näher erläutert.

In den Zeichnungen zeigen:

Fig. 1 in einem Blockschaltbild einen Frequenzsynthesizer mit Grobeinstellung der Frequenz mittels eines Drehkondensators;

Fig. 2 eine Variante des Frequenzsynthesizers nach Fig. 1 mit der zusätzlichen Möglichkeit einer Feineinstellung der Frequenz durch einen Schalter.

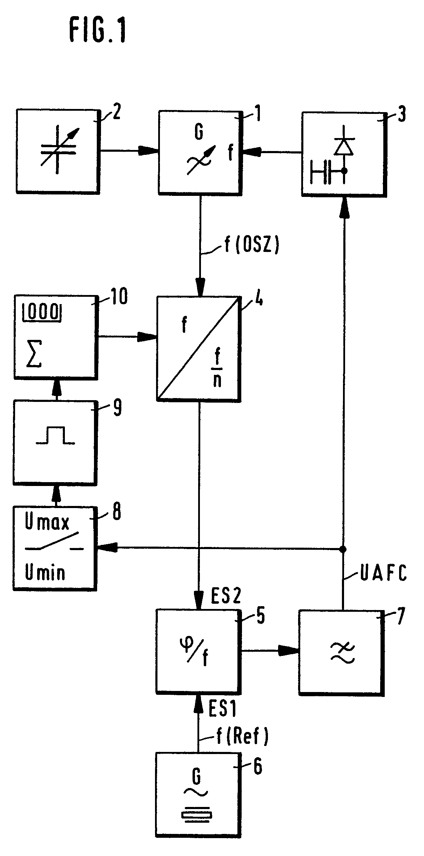

Der in Fig. 1 dargestellte Frequenzsynthesizer besitzt einen spannungsgeregelten Oszillator 1, dessen Ausgangsfrequenz über einen von Hand einstellbaren Drehkondensator 2 im Grobbereich und über eine eine Kapazitätsdiode enthaltende Steuerschaltung 3 im Nachstimmbereich veränderbar ist.

Das Ausgangssignal mit der Frequenz f (OSZ) des spannungsgeregelten Oszillators 1 wird einem einstellbaren Frequenzteiler 4 zugeführt, dessen Ausgangssignal als Eingangssignal ES2 einem als Phasenfrequenzvergleicher aufgebauten Komparator 5 zugeführt wird, der als weiteres Eingangssignal ES1 das Ausgangssignal eines quarzgesteuerten Referenzoszillators 6 mit der Frequenz f (Ref) erhält.

Der Komparator 5 erzeugt ein Nachstimmsignal UAFC, über ein Regelschwingungen verhindertes Tiefpaßfilter 7 der Steuerschaltung 3 zugeführt wird.

Die Einstellung des Frequenzteilers 4 erfolgt über eine elektronische Einstellvorrichtung, die einen von einem Taktgeber 9 aus angesteuerten Zähler 10 aufweist. Der Taktgeber 9 wird über eine Schaltvorrichtung 8 ein- oder ausgeschaltet in Abhängigkeit vom Wert des der Schaltvorrichtung 8 zugeführten Nachstimmsignals. Der Komparator 5 ist so ausgebildet, daß er jedesmal dann, wenn die Frequenzen seiner beiden Eingangssignale ES1 und ES2 soweit auseinanderliegen, daß der vorgesehene Nachstimmbereich überschritten ist, ein Nachstimmsignal mit einem maximalen Spannungswert Umax oder einem minimalen Spannungswert Umin liefert. Der Taktgeber 9 wird immer dann eingeschaltet, wenn die an der Schaltvorrichtung 8 festgestellte Spannung den Wert Umax oder Umin besitzt und wird abgeschaltet, sobald der Spannungswert des Nachstimmsignals zwischen diesen beiden Werten liegt.

Die Funktionsweise des Frequenzsynthesizers nach Fig. 1 ist folgende:

Am Drehkondensator 2 wird die Frequenz des Ausgangssignals des spannungsgeregelten Oszillators 1 grob eingestellt. Zunächst liegt die Frequenz des Ausgangssignals des Frequenzteilers 4 weit entfernt von der Frequenz f (Ref) des Referenzoszillators 6, d. h. das Nachstimmsignal UAFC weist den Spannungswert Umax oder Umin auf. Dies bedeutet, daß der Zähler 10 zählt und dabei den Teilungsfaktor n des Frequenzteilers 4 solange verändert, bis aufgrund der entsprechenden Frequenzänderung am Eingangssignal ES2 des Komparators 5 für ein bestimmtes n der Spannungswert des Nachstimmsignals UAFC zwischen den Werten Umin und Umax liegt. Die Frequenz des Ausgangssignals des spannungsgeregelten Oszillators bleibt während dieses Zählvorganges solange unverändert, bis der Teilungsfaktor n erreicht ist, bei dem die Spannung UAFC von der einen Extremspannung in die andere umschlägt. In diesem Augenblick rastet das System ein und die Frequenz des Ausgangssignals am spannungsgeregelten Oszillator 1 wird auf einen Wert nachgestimmt, der dem Produkt aus der Frequenz f (Ref) des Referenzoszillators und dem eingestellten Teilungsfaktor n entspricht.

Wenn also beispielsweise f (Ref) gleich 1 MHz ist und mittels des Drehkondensators f (OSZ) grob auf den Wert 53,1 MHz eingestellt ist, zählt der Zähler 10 abwärts bis n gleich 53 und das Ausgangssignal rastet auf den Frequenzwert f (OSZ) gleich 53 MHz ein.

Geht man bei der Einstellung am Drehkondensator von einem Grobraster von +- 500 kHz aus, so muß der Frequenznachstimmbereich von Umax bis Umin kleiner, also beispielweise +- 300 kHz sein, da sonst die Gefahr einer Fehlrastung des Systems im Abstand von +- 1 MHz besteht. Der Drehkondensator 2 muß deshalb die freischwingende Frequenz f (OSZ) des Ausgangssignals möglichst präzise auf den gewünschten Frequenznennwert einstellen, also beispielsweise mit einer Maximaltoleranz von etwa +-150 kHz.

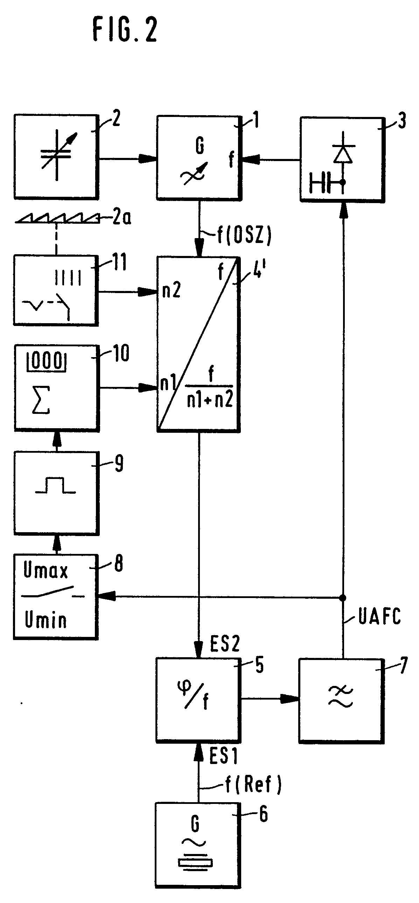

In Fig. 2 ist eine Variante des Frequenzsynthesizers nach Fig. 1 dargestellt, mit der es möglich ist, ein feineres Frequenzraster für das Ausgangssignal des spannungsgeregelten Oszillators 1 zu erreichen.

Dies wird dadurch erzielt, daß der zu erzielende Teilungsfaktor in eine Summe zweier Teilungsfaktoren zerlegt wird, so daß gilt n = n1 + n2. Der eine der beiden Summanden n1 wird nach wie vor durch den Zählerstand des Zählers 10 bestimmt, während der andere Summand n2 durch Einstellung eines zusätzlichen Drehschalters 11 mit mehreren Schaltstellungen bewirkt wird. Dadurch wird es möglich, eine beliebig feine Rasterung zu erzielen, ohne daß beim Einstellen und Nachstimmen der Schaltung der Zähler 10 sämtliche Teilungsschritte durchlaufen muß.

Dies soll nachfolgend an einem Zahlenbeispiel erläutert werden.

Die Frequenz des vom Referenzoszillator 6 abgegebenen Referenzsignals betrage f (Ref) = 25 kHz.

Am Drehkondensator 2 ist die Frequenz in Rastschritten von 1 MHz veränderbar.

Wenn nun beispielsweise ein Ausgangssignal mit dem Wert f (OSZ) = 43.575 MHz erreicht werden soll, so wird dieser Wert aufgeteilt in:
43.575 MHz = 43 MHz + 575 kHz.

Die beiden Summanden der Teilungsfaktoren werden folgendermaßen gewählt:
n1 = 43000 : 25 = 1720 -eingestellt am Drehkondensator 2
n2 = 575 : 25 = 23 -eingestellt am Drehschalter 11
Dies ergibt einen Wert für den Gesamtteilungsfaktor n = 1743.

Der Zähler 10 zählt nun entweder zyklisch in einer Richtung oder in beiden Richtungen bis zum Wert des Teilungsfaktors n1 = 1720, wobei er bei jedem Zählschritt 40 Einheiten für den Teilungsfaktor, die einem Frequenzwert von 1 MHz entsprechen, weiterzählt. Beim Wert n1 = 1720, der dem Gesamtwert n = 1743 entspricht, rastet das System ein.

Soll die Frequenz um 1 MHz erhöht werden, so wird am Drehkondensator 2 um eine Raste des Rastwerks 2a weitergeschaltet auf den Wert f (OSZ) = 44.575 MHz.

Die Summanden des Teilungsfaktors sind nun folgendermaßen aufgeteilt:
n1 = 44000 : 25 = 1760
n2 = 575 : 25 = 23
Dies ergibt als Gesamtteilungsfaktor n = n1 + n2 = 1783.

Soll das Feinraster verändert werden, beispielsweise durch Weiterschalten am Drehschalter 11 um einen Kanal entsprechend einem Wert der Ausgangsfrequenz von 25 kHz, so ergibt sich folgendes:
f(OSZ) = 44,600 MHz
n1 = 44000 : 25 = 1760
n2 = 600 : 25 = 24
Der Summenwert n1 + n2 = 1784.

Um hier Fehlrastungen zu vermeiden und eine möglichst präzise Einstellung des Frequenznennwertes zu erreichen, ist das Rastwerk 2a des Drehkondensators 2 mechanisch mit dem Drehschalter 11 unter Zwischenschaltung einer entsprechenden Untersetzung verbunden, so daß der Drehkondensator beim Betätigen des Drehschalters 11 entsprechend mitgedreht wird.

Die Frequenzgenauigkeit, mit der das Ausgangssignal einstellbar ist, ist außerordentlich hoch und entspricht der Genauigkeit der Referenzfrequenz. Es hat sich gezeigt, daß eine Genauigkeit des Ausgangssignals im angegebenen Beispielsbereich von 35 ppm erzielbar ist, was einer Frequenztoleranz von +- 1,75 kHz entspricht, die auf allen Kanälen gleich groß ist.

**Ansprüche**

1. Frequenzsynthesizer mit einem spannungsgeregelten Oszillator, der über seinen ganzen Frequenzbereich in Rastschritten eines vorgegebenen Frequenzrasters mittels eines einstellbaren frequenzbestimmenden Elements abstimmbar ist und mit einem Referenzoszillator, der ein Referenzsignal mit fest vorgegebener Frequenz abgibt, welches als erstes Eingangssignal einem Komparator zugeführt wird, dem gleichzeitig ein zweites Eingangssignal zugeführt wird, dessen Frequenz eine Funktion der Frequenz des Ausgangssignals des spannungsgeregelten Oszillators ist und der in Abhängigkeit von der Frequenzdifferenz und/oder der Phasendifferenz zwischen dem ersten und dem zweiten Eingangssignal ein Nachstimmsignal erzeugt, welches dem spannungsgeregelten Oszillator zur Nachstimmung der Frequenz seines Ausgangssignals auf den durch das Referenzsignal definierten Wert zugeführt wird, dadurch gekennzeichnet, daß zur Erzeugung des dem Komparator (5) zugeführten zweiten Eingangssignals (ES2) ein einstellbarer Frequenzteiler (4, 4') dient, dessen Einstellung mittels einer ansteuerbaren elektronischen Einstellvorrichtung (8-9-10) erfolgt, der das Nachstimmsignal (UAFC) zugeführt wird und die den Teilungsfaktor (n) des Frequenzteilers (4, 4') solange verändert bis die Spannung des Nachstimmsignals (UAFC) innerhalb eines vorgegebenen Spannungsbereiches (Umax-Umin) einen definierten Wert annimmt, der die Frequenz des Ausgangssignals des spannungsgeregelten Oszillator (1) auf die mit dem erreichten Teilungsfaktor multiplizierte Frequenz des zweiten Eingangssignals (ES2) nachstimmt und diese Frequenz des Ausgangssignals innerhalb des durch das Raster vorgegebenen und am frequenzbestimmenden Element (2) eingestellten Frequenzteilbereichs liegt.

2. Frequenzsynthesizer nach Anspruch 1, dadurch gekennzeichnet, daß die elektronische Einstellvorrichtung einen von einem Taktgeber (9) angesteuerten Zähler (10) aufweist, wobei die Ein-Ausschaltung des Taktgebers (9) durch eine Schaltvorrichtung (8) erfolgt, der das Nachstimmsignal (UAFC) zugeführt wird und die den Taktgeber (9) solange eingeschaltet läßt, bis die Spannung des Nachstimmsignals (UAFC) einen Wert zwischen einem vorgegebenen Maximalwert (Umax) und einen vorgegebenen Minimalwert (Umin) erreicht und ihn dann abschaltet, wobei nach Abschaltung des Taktgebers (9) das durch die elektronische Einstellvorrichtung erzielte Frequenzteilungsverhältnis konstant bleibt.

3. Frequenzsynthesizer nach Anspruch 2, dadurch gekennzeichnet, daß der Zähler (10) nur in einer Zählrichtung zählt.

4. Frequenzsynthesizer nach Anspruch 2, dadurch gekennzeichnet, daß der Zähler (10) in beiden Zählrichtungen zählt.

5. Frequenzsynthesizer nach einem der Ansprüche 1 bis 4, dadurch gekennzeichnet, daß der Teilungsfaktor (n1) des Frequenzteilers (4') in Teilschritten größer als 1 durch die elektronische Einstellvorrichtung (8-9-10) verändert wird und die zwischen diesen Teilschritten liegenden Werte des Teilungsfaktors (n2) zur Feineinstellung der Ausgangsfrequenz des spannungsgeregelten Oszillators (1) durch einen mechanischen Schalter (11) einstellbar sind.

6. Frequenzsynthesizer nach Anspruch 5, dadurch gekennzeichnet, daß der mechanische Schalter (11) mit dem Rastwerk (2a) des frequenzbestimmenden Elements (2) derart mechanisch gekoppelt ist, daß dieses bei der Betätigung des Schalters (11) um ein der eingestellten Frequenzveränderung entsprechendes Stück mitgeführt wird.

7. Frequenzsynthesizer nach einem der Ansprüche 1 bis 6, dadurch gekennzeichnet, daß als einstellbares frequenzbestimmendes Element ein Drehkondensator (2) dient.

8. Frequenzsynthesizer nach einem der Ansprüche 1 bis 6, dadurch gekennzeichnet, daß als einstellbares frequenzbestimmendes Element ein Variometer dient.

# FIG.1

# FIG.2